# EUROPÄISCHE PATENTSCHRIFT

(11) **EP 0 313 955 B1**
(45) Veröffentlichungstag und Bekanntmachung des Hinweises auf die Patenterteilung: **17.03.1993**
(21) Anmeldenummer: 88117263.9
(22) Anmeldetag: 17.10.1988
(51) Int. Cl.: H05K 7/14, H05K 9/00

(54) **Schutzvorrichtung für ein Stachelfeld einer Rückwandleiterplatte eines Baugruppenträgers**
Protecting device for backpanel pin assembly of an electronic cabinet
Dispositif de protection pour un ensemble de broches sur une plaque de circuit de fond de panier d'une armoire électronique

(30) Priorität: 30.10.1987 DE 8714496 U
(43) Veröffentlichungstag der Anmeldung: 03.05.1989
(73) Patentinhaber: SIEMENS AKTIENGESELLSCHAFT, 80333 München (DE)
(72) Erfinder: Assel, Eugen, Dipl.-Ing.(FH), D-8729 Knetzgau (DE); Dasbach, Burkhard, Dipl.-Ing.(FH), D-8520 Erlangen (DE); Gebhard, Bruno, Dipl.-Ing.(FH), D-8550 Forchheim (DE)

(56) Entgegenhaltungen:
- DE-A- 1 640 511
- DE-A- 2 813 812
- DE-A- 3 340 334

## Beschreibung

Die Erfindung bezieht sich auf eine Schutzvorrichtung für ein Stachelfeld auf der Außenseite einer Rückwandleiterplatte eines Baugruppenträgers, welcher mindestens eine hintere Querschiene aufweist.

Aus dem Katalog ET 1.1 mit dem Titel "Einbausystem ES 902 C 19-Zoll-Bauweise" der Firma Siemens AG, Ausgabe 1987, Bestell-Nr. E 86010-K4101-A211-A1, ist ein Verdrahtungsschirmblech für eine Rückwandleiterplatte eines Baugruppenträgers bekannt. Dieses Verdrahtungsschirmblech ist allseitig gekantet. Die stirnseitigen Abkantungen des Verdrahtungsschirmbleches enthalten eingepreßte Muttern für Sperrzahnschrauben. Verschraubt ist dieses Verdrahtungsschirmblech mit den Seitenteilen des Baugruppenträgers. Nachteilig bei diesem Verdrahtungsschirmblech ist es, daß durch die allseitige Abkantung ein großes Lager- bzw. Transportvolumen benötigt wird. Außerdem muß bei einer Reparatur der Rückwandleiterplatte eines in einem Schrank bzw. Gehäuse eingebauten Baugruppenträgers dieser Baugruppenträger erst ausgebaut werden, damit man das Verdrahtungsschirmblech abnehmen kann, oder man baut den Baugruppenträger in einen Schrank bzw. ein Gehäuse, der bzw. das von der Seite zugänglich ist, ein.

Eine andere Schutzvorrichtung ist aus EP-A-0 133 379 bekannt und betrifft eine Vielzahl von flachen Gehäusen, welche jeweils eine Baugruppe enthalten und in Form eines Stapels übereinanderliegend mittels seitlicher Schienen verbunden sind. Der Gehäusestapel kann mit einem Boden und Deckel versehen sein. Auf der Rückseite eines jeden Gehäuses sind Anschlußleisten für Kabel vorgesehen, welche aus dem Gehäusestapel herausragen.

Der Erfindung liegt nun die Aufgabe zugrunde, eine Schutzvorrichtung für ein Stachelfeld einer Rückwandleiterplatte eines Baugruppenträgers anzugeben, bei dem das Verdrahtungsschirmblech einer Rückwandleiterplatte eines in einem Gehäuse eingebauten Baugruppenträgers von der Rückseite ohne Ausbau des Baugruppenträgers abnehmbar ist, wobei das Lager- bzw. Transportvolumen erheblich verringert wird.

Diese Aufgabe wird gelöst durch die Vorrichtung von Anspruch 1. Weitere vorteilhafte Ausgestaltungen der Erfindung sind in den Unteransprüchen angegeben.

Diese Schutzvorrichtung für ein Stachelfeld einer Rückwandleiterplatte eines Baugruppenträgers ist in zwei Seitenprofile und einem Verdrahtungsschirmblech aufgeteilt. Das Verdrahtungsschirmblech bleibt für die Lagerung und bei der Lieferung zum Kunden ein ebenes Blech, das durch Perforation festgelegte Sollbiegestellen aufweist. Erst bei der Montage der Schutzvorrichtung wird durch einfaches Abkanten von Hand oder mit einfachen Hilfsmitteln das Verdrahtungsschirmblech erstellt. Dadurch läßt sich das Lager-bzw. Transportvolumen erheblich verringern. Außerdem können bei diesem ebenen Verdrahtungsschirmblech nachträglich Öffnungen gestanzt werden, durch die die Übergabesteckverbinder der Rückwandleiterplatte gesteckt werden.

Ein weiterer Vorteil dieser Aufteilung der Schutzvorrichtung für ein Stachelfeld einer Rückwandleiterplatte ist es, daß das Verdrahtungsschirmblech aus einer Blechtafel oder aus einer gecoilten Band gefertigt werden kann. Die Seitenprofile werden durch einfaches Ablängen von einem als Meterware gelieferten Strangpreßprofil gewonnen. Somit können die Einzelteile dieser Schutzvorrichtung besonders wirtschaftlich hergestellt werden.

Ein besonderer Vorteil der Aufteilung der Schutzvorrichtung ist es, daß das Verdrahtungsschirmblech mittels Befestigungsmittel über die Aufnahme mit den Seitenprofilen lösbar verbunden werden kann. D.h., das Verdrahtungsschirmblech wird erst montiert, wenn die Seitenprofile mit dem Baugruppenträger verbunden sind. Da die Befestigungsebene parallel zur Rückwandleiterplatte angeordnet ist, kann im Bedarfsfall das Verdrahtungsschirmblech vom eingebauten Baugruppenträger von der Rückfront abmontiert werden. Ferner dienen die Seitenprofile, solange das Verdrahtungsschirmblech nicht montiert ist, als Stachelfeldschutz, da die Seitenprofile länger sind als die Stacheln des Stachelfeldes.

In einer weiteren Ausführungsform der Schutzvorrichtung sind jeweils ein Seitenteil des Baugruppenträgers und ein Seitenprofil einstückig geformt. Durch diese Maßnahme entfallen zusätzliche Befestigungsmittel und eine zusätzliche Bearbeitung. Dadurch verringern sich die Teile für eine Schutzvorrichtung auf ein ebenes Blech, das erst kurz vor der Montage abgekantet wird. Somit verringert sich das Lager- bzw. Transportvolumen noch mehr.

Zur weiteren Erläuterung der Erfindung wird auf die Zeichnung Bezug genommen, in der Ausführungsbeispiele einer Schutzvorrichtung für ein Stachelfeld einer Rückwandleiterplatte eines Baugruppenträgers nach der Erfindung schematisch veranschaulicht ist.
- FIG 1: zeigt ein erstes Ausführungsbeispiel der Schutzvorrichtung ohne ein Verdrahtungsschirmblech, die
- FIG 2: stellt ein zweites Ausführungsbeispiel der Schutzvorrichtung ohne ein Verdrahtungsschirmblech dar und die
- FIG 3: veranschaulicht eine vollständige Schutzvorrichtung.

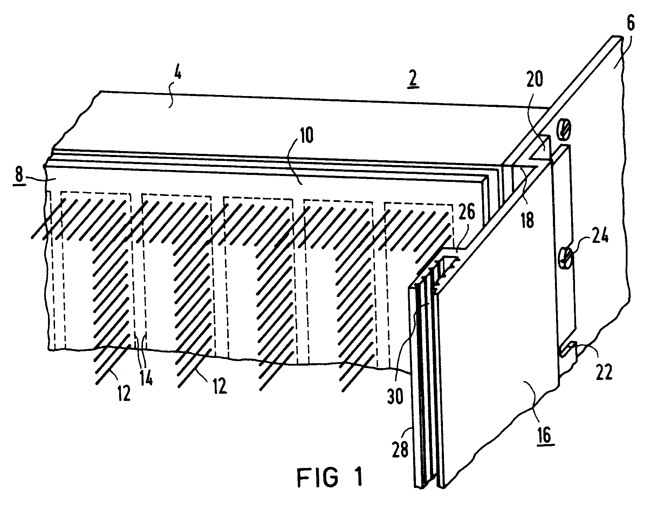

Die FIG 1 zeigt einen Teil eines Baugruppenträgers 2, von dem eine obere, hintere Querschiene 4, ein Seitenteil 6 und eine Rückwandleiterplatte 8 dargestellt ist. Die Rückwandleiterplatte 8 ist mit den Querschienen des Baugruppenträgers 2 verschraubt. Die den Baugruppen abgewandte Seite 10 der Rückwandleiterplatte 8 enthält eine Vielzahl von Stacheln 12, wobei jeweils eine Untermenge dieser Stacheln 12 zu einem Steckverbinder gehören, die auf der den Baugruppen zugewandten Seite der Rückwandleiterplatte 8 angebracht sind. Die räumliche Lage der Steckverbinder ist auf der den Baugruppen abgewandten Seite 10 der Rückwandleiterplatte 8 jeweils durch eine unterbrochene Linie 14 angedeutet. Ein solches Stachelfeld kann in Abhängigkeit der im Baugruppenträger 2 eingeschobenen Baugruppen mit einer Wire-Wrap-Verdrahtung versehen sein, die aus Übersichtlichkeitsgründen nicht dargestellt ist.

Jedes Seitenteil 6 des Baugruppenträgers 2 ist mit einem U-förmigen Seitenprofil 16 versehen. Dieses Seitenprofil 16 ist aus einem Aluminium-Strangpreßprofil vom laufenden Meter mittels Ablängen hergestellt. Durch vorbestimmte Teilungsschritte, beispielsweise 25 mm, kann das Seitenprofil 16 jeder Baugruppenträgerhöhe angepaßt werden. An einem Schenkel 18 des Seitenprofils 16 ist eine streifenförmige Befestigungsfahne 20 angebracht. Diese Befestigungsfahne 20 ist mit Ausnehmungen 22 versehen, die über die gesamte Länge der Befestigungsfahne 20 in regelmäßigen Abständen verteilt sind. Dabei sind die Öffnungen der Ausnehmungen 22 vom Schenkel 18 des U-förmigen Seitenprofils 16 abgewandt. Dies hat den Vorteil, daß bei der Montage des U-förmigen Seitenprofils 16 an das rückseitige Ende des Seitenteils 6 des Baugruppenträgers 2 das Seitenprofil 16 auf vormontierte Befestigungsmittel 24 geschoben werden kann, die dann nur noch angezogen werden brauchen. Ein anderer Schenkel 26 des U-förmigen Seitenprofils 16 ist mit einer Aufnahme 28 versehen. Diese Aufnahme 28 hat ein über die gesamte Baugruppenträgerhöhe erstreckendes Längsgewinde 30. Dadurch hat man die Möglichkeit, an jeder beliebigen Stelle der Aufnahme 28 eine Schraube in die Aufnahme 28 zu schrauben. D.h., man ist in Bezug auf Toleranzen für einen Gegenstand, der an die Seitenprofile 16 geschraubt werden soll, nicht festgelegt, wodurch die Fertigung des nachfolgenden Gegenstandes wirtschaftlicher ist. Die Seitenprofile 6 sind in der Art mit den Seitenteilen 6 des Baugruppenträgers 2 verbunden, daß die Öffnung des U-förmigen Profils 16 jeweils dem Stachelfeld der Rückwandleiterplatte 8 zugewandt sind. Außerdem sind die Seitenprofile 16 länger als die Stacheln 12 des Stachelfeldes. Somit erfüllen die Seitenprofile 16 noch eine zusätzliche Funktion, nämlich eine Schutzfunktion für das Stachelfeld.

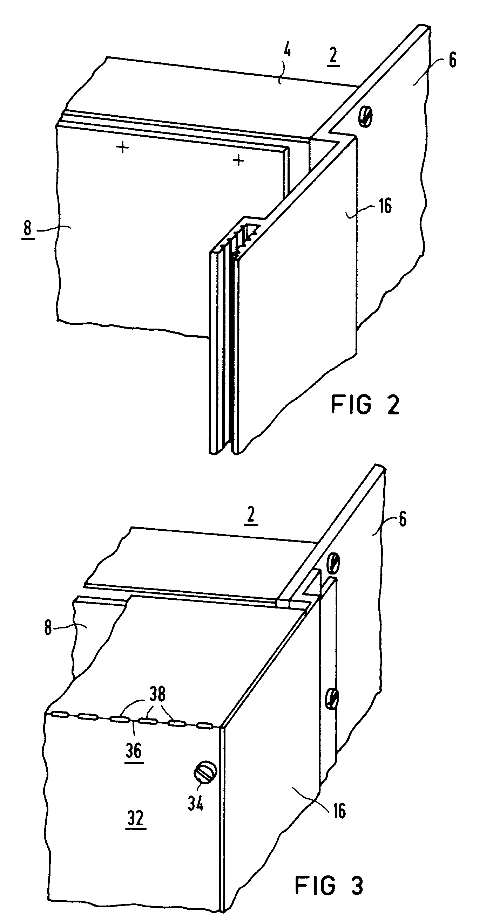

In FIG 2 ist eine weitere Ausgestaltung der Schutzvorrichtung dargestellt, wobei aus Übersichtlichkeitsgründen ein Verdrahtungsschirmblech nicht dargestellt ist. Bei dieser Ausführungsform sind die Seitenteile 6 des Baugruppenträgers 2 und die U-förmigen Seitenprofile 16 einstückig geformt. Dadurch werden zusätzliche Befestigungsmittel und eine zusätzliche Bearbeitung eingespart.

In FIG 3 ist eine vollständig geschlossene Schutzvorrichtung für ein Stachelfeld einer Rückwandleiterplatte 8 eines Baugruppenträgers 2 dargestellt. Dabei ist ein Verdrahtungsblech 32, das längsseitig abgekantet ist, mittels Befestigungsmittel 34 lösbar mit den Seitenprofilen 16 verbunden. Die Längskanten 36 weisen Perforationslöcher 38 auf. Dieses Verdrahtungsblech 32 wird aus einer Blechtafel oder aus einem gecoilten Blechband gefertigt, wobei als Blech ein Aluminiumblech vorgesehen ist. Die Sollbiegestellen werden durch eine Perforation vorbestimmt. Diese ebenen, mit Sollbiegestellen versehenen Bleche werden erst kurz vor der Montage durch Abkanten von Hand oder mit einfachen Hilfsmitteln in den Endzustand gebracht. Dazu wird das Lager- bzw. Transportvolumen wesentlich verringert. Nachdem das Verdrahtungsschirmblech 32 mit den Seitenprofilen 16 verschraubt ist, können Störsignale vom Stachelfeld abgehalten werden. Außerdem bietet diese Schutzvorrichtung jedermann und auch den Bauelementen indirekt über die Stachel Schutz gegen Berührungen.

## Patentansprüche

1. Schutzvorrichtung für ein Stachelfeld (12) auf der Außenseite (10) einer Rückwandleiterplatte (8) eines Baugruppenträgers (2), welcher mindestens eine hintere Querschiene (4) aufweist, wobei
a) an den beiden Seiten der Querschiene (4) je
a1) ein Seitenteil (6) vorgesehen ist, welches mit dem jeweiligen Ende der Querschiene (4) verbunden ist, und
a2) ein U-förmiges Seitenprofil (16) vorgesehen ist, welches über dessen einen Schenkel (18) im Bereich der Querschiene (4) mit dem jeweiligen Seitenteil (6) derart verbunden ist, daß das U-förmige Seitenprofil (16) mit dem anderen Schenkel (26) über das Stachelfeld (12) nach hinten herausragend dieses seitlich abdeckt, und der andere Schenkel (26) rechtwinklig eine Aufnahme (28) mit einem Längsgewinde (30) aufweist, und
b) ein längsseitig abgekantetes Verdrahtungsschirmblech (32) vorgesehen ist, welches über Befestigungsmittel (34) mit den Längsgewinden (30) an den anderen Schenkeln (28) der U-förmigen Seitenprofile (16) derart lösbar verbunden ist, daß das Stachelfeld (12) allseitig umschlossen ist.

2. Schutzvorrichtung nach Anspruch 1, wobei der eine Schenkel (18) des jeweiligen U-förmigen Seitenprofiles (16) rechtwinkelig eine streifenförmige, mit Ausnehmungen (22) versehene Befestigungsfahne (20) aufweist, über die das jeweilige U-förmige Seitenprofil (16) im Bereich der Querschiene (4) mit dem jeweiligen Seitenteil (6) verbunden ist.

3. Schutzvorrichtung nach Anspruch 1, wobei jeweils ein Seitenteil (6) und ein U-förmiges Seitenprofil (16) einstückig ausgeführt sind.

## Claims

1. Protective device for a pin field (12) on the outer side (10) of a rear-wall printed-circuit board (8) of a mounting rack (2), which has at least one rear crossbar (4), whereby
a) there is provided at both sides of the crossbar (4) in each case
a1) a side part (6) which is connected to the respective end of the crossbar (4), and
a2) a U-shaped side profile (16) which is connected by way of its one limb (18) in the region of the crossbar (4) to the respective side part (6) in such a way that the U-shaped side profile (16) laterally covers the pin field (12) with the other limb (26), projecting out to the rear beyond the pin field (12), and the other limb (26) has at right angles a retainer (28) with a longitudinal thread (30), and
b) a wiring screening plate (32) folded longitudinally is provided, which is releasably connected by way of fastening means (34) to the longitudinal threads (30) at the other limbs (20) of the U-shaped side profiles (16) in such a way that the pin field (12) is enclosed on all sides.

2. Protective device according to claim 1, whereby the one limb (18) of the respective U-shaped side profile (16) has at right angles a strip-shaped fastening lug (20) provided with recesses (22), by means of which fastening lug the respective U-shaped side profile (16) is connected in the region of the crossbar (4) to the respective side part (6).

3. Protective device according to claim 1, whereby in each case a side part (6) and a U-shaped side profile (16) are constructed in one piece.

## Revendications

1. Dispositif de protection pour un panneau à broches situées sur la face extérieure (10) d'une plaquette à circuits imprimés (8), destinée à être montée sur une paroi arrière d'un porte-modules (2) qui comporte au moins un rail transversal arrière (4), et dans lequel
a) il est prévu, sur les deux faces du rail transversal (4), respectivement
a1) un élément latéral (6), qui est raccordé à l'extrémité respective du rail transversal (4), et
a2) un profilé latéral en forme de U (16), qui est raccordé, par l'intermédiaire de l'une de ses branches (18), dans la zone du rail transversal (4), à l'élément latéral respectif (6) de sorte que le profilé latéral en forme de U (16) recouvre latéralement, par son autre branche (26), le panneau à broches (12), en faisant saillie vers l'arrière au-delà de ce panneau à broches, et l'autre broche (26) possède perpendiculairement un logement (28) comportant un filetage longitudinal (30), et
b) une tôle (32) de protection du câblage, qui est biseautée sur ses côtés longitudinaux et qui est raccordée de façon amovible, par l'intermédiaire de moyens de fixation (34) aux filetages longitudinaux (30) présents sur les autres branches (28) des profilés latéraux (16) en forme de U, de sorte que le panneau à broches (12) est entouré de tous côtés.

2. Dispositif de protection suivant la revendication 1, dans lequel une branche (18) du profilé latéral respectif en forme de U (16) possède, perpendiculairement, une languette de fixation en forme de bande (20), qui est pourvue d'un évidement (22), et au moyen de laquelle le profilé latéral respectif en forme de U (16) est raccordé, au niveau du rail transversal (4), à l'élément latéral respectif (6).

3. Dispositif de protection suivant la revendication 1, dans lequel respectivement un élément latéral (6) et un profilé latéral en forme de U (16) sont réalisés d'un seul tenant.
